# EUROPEAN PATENT APPLICATION

(11) **EP 4 642 206 A1**
(43) Date of publication of application: **29.10.2025**
(21) Application number: 25159997.3
(22) Date of filing: 25.02.2025
(51) Int. Cl.: H10K 59/38, H10K 50/844, H10K 59/88, H10K 50/858

(54) **DISPLAY DEVICE AND ELECTRONIC DEVICE INCLUDING THE SAME**

(30) Priority: 24.04.2024 KR 20240054564
(71) Applicant: Samsung Display Co., Ltd., Yongin-si, Gyeonggi-do 17113 (KR)
(72) Inventor: SEO, Jina, Yongin-si, Gyeonggi-do (KR)
(74) Representative: Gulde & Partner

(57) **Abstract**

A display device includes: a substrate (SUB) including a display area (DA) and a dam area (DAMA) surrounding the display area; a light emitting layer disposed in the display area on the substrate; a dam portion (DAP) disposed in the dam area on the substrate; an encapsulation layer (TFE) disposed in the display area on the light emitting layer and disposed in the dam area on the dam portion; an organic protective (APL) layer disposed in the display area on the encapsulation layer, directly contacting the encapsulation layer in the display area, not overlapping the encapsulation layer in the dam area in a plan view, and including an organic material; and a color filter layer (CFL) disposed in the display area on the organic protective layer, directly contacting the organic protective layer in the display area, and not overlapping the encapsulation layer in the dam area in the plan view.

## Description

### BACKGROUND

### 1. Field

Embodiments of the disclosure relate generally to a display device. More particularly, Embodiments of the disclosure relate to a display device that provides visual information and an electronic device including the display device.

### 2. Description of the Related Art

With the development of information technology, the importance of a display device, which is a connection medium between a user and information, has been highlighted. For example, the use of display devices such as liquid crystal display ("LCD") device, organic light emitting diode ("OLED") display device, plasma display panel ("PDP") device, quantum dot display device or the like is increasing.

Recently, a head mounted display ("HMD") including the display device has been developed. A head-mounted display is a glasses-type monitor device for virtual reality ("VR") or augmented reality ("AR") that is worn in the form of glasses, helmets, etc. and focuses on a close distance in front of the user's eyes. The head mounted display may provide an image displayed on the display device to the user's eyes through a lens. The head mounted display may include a high-resolution micro-OLED, which may be an organic light emitting diode on silicon ("OLEDoS") formed using a semiconductor process on a silicon wafer substrate.

### SUMMARY

Embodiments provide a display device with improved display quality and improved reliability of an encapsulation layer.

Embodiments provide an electronic device including the display device.

A first aspect of the present disclosure relates to a display device including: a substrate including a display area, a dam area surrounding the display area, and a pad area spaced apart from the dam area in one direction; a light emitting layer disposed in the display area on the substrate; a dam portion disposed in the dam area on the substrate; an encapsulation layer disposed in the display area on the light emitting layer and disposed in the dam area on the dam portion; an organic protective layer disposed in the display area on the encapsulation layer, and including an organic material, where the organic protective layer directly contacts an upper surface of the encapsulation layer in the display area, and does not overlap the encapsulation layer in the dam area in a plan view; and a color filter layer disposed in the display area on the organic protective layer, where the color filter layer directly contacts an upper surface of the organic protective layer in the display area, and does not overlap the encapsulation layer in the dam area in the plan view.

In an embodiment, the color filter layer may be spaced apart from the encapsulation layer with the organic protective layer interposed therebetween.

In an embodiment, the display device may further include a pad electrode disposed in the pad area on the substrate. In such an embodiment, the organic protective layer may cover the pad electrode in the pad area.

In an embodiment, the display device may further include a flattening layer disposed in the display area on the color filter layer and disposed in the dam area on the encapsulation layer and a lens layer disposed in the display area and the dam area on the flattening layer.

In an embodiment, a level of an upper surface of the flattening layer in the display area may be different from a level of the upper surface of the flattening layer in the dam area.

In an embodiment, the lens layer may include a plurality of micro lenses overlapping the display area in the plan view. In such an embodiment, the plurality of micro lenses may be spaced apart from the dam area in the plan view.

In an embodiment, the encapsulation layer may include a first inorganic encapsulation layer disposed on the dam portion and covering the dam portion, an organic encapsulation layer disposed on the first inorganic encapsulation layer, where the organic encapsulation layer does not overlap at least a portion of the dam portion in the plan view, and a second inorganic encapsulation layer disposed on the first inorganic encapsulation layer and covering the dam portion and the first inorganic encapsulation layer. In such an embodiment, the flattening layer may directly contact an upper surface of the second inorganic encapsulation layer in the dam area.

The display device according to another embodiment of the disclosure includes: a substrate including a display area, a dummy pixel area surrounding the display area, a dam area surrounding the dummy pixel area, and a pad area spaced apart from the dam area in one direction; a light emitting layer disposed in the display area on the substrate; a dummy electrode disposed in the dummy pixel area on the substrate; a dam portion disposed in the dam area on the substrate; an encapsulation layer disposed in the display area on the light emitting layer, disposed in the dummy pixel area on the dummy electrode, and disposed in the dam area on the dam portion; an organic protective layer disposed in the display area and the dummy pixel area on the encapsulation layer, and including an organic material, where the organic protective layer directly contacts an upper surface of the encapsulation layer in the display area and the dummy pixel area, and does not overlap the encapsulation layer in the dam area in a plan view; and a color filter layer disposed in the display area and the dummy pixel area on the organic protective layer, where the color filter layer directly contacts an upper surface of the organic protective layer in the display area and the dummy pixel area, and does not overlap the encapsulation layer in the dam area in the plan view.

In an embodiment, the color filter layer may be spaced apart from the encapsulation layer with the organic protective layer interposed therebetween.

In an embodiment, the display device may further include a pad electrode disposed in the pad area on the substrate. In such an embodiment, the organic protective layer may cover the pad electrode in the pad area.

In an embodiment, the display device may further include a flattening layer disposed in the display area and the dummy pixel area on the color filter layer and disposed in the dam area on the encapsulation layer and a lens layer disposed in the display area, the dummy pixel area, and the dam area on the flattening layer.

In an embodiment, a level of an upper surface of the flattening layer in the display area may be equal to a level of the upper surface of the flattening layer in the dummy pixel area.

In an embodiment, a level of an upper surface of the flattening layer in the display area may be different from a level of the upper surface of the flattening layer in the dam area.

In an embodiment, the encapsulation layer may include a first inorganic encapsulation layer disposed on the dam portion and covering the dam portion, an organic encapsulation layer disposed on the first inorganic encapsulation layer, where the organic encapsulation layer does not overlap at least a portion of the dam portion in the plan view, and a second inorganic encapsulation layer disposed on the first inorganic encapsulation layer and covering the dam portion and the first inorganic encapsulation layer. In such an embodiment, the flattening layer may directly contact an upper surface of the second inorganic encapsulation layer in the dam area.

A second aspect of the present disclosure relates to an electronic device according to an embodiment of the disclosure includes: the display device as described in the embodiments above; and a power supply configured to provide power to the display device. The display device includes: a substrate including a display area, a dam area surrounding the display area, and a pad area spaced apart from the dam area in one direction; a light emitting layer disposed in the display area on the substrate; a dam portion disposed in the dam area on the substrate; an encapsulation layer disposed in the display area on the light emitting layer and disposed in the dam area on the dam portion; an organic protective layer disposed in the display area on the encapsulation layer, and including an organic material, where the organic protective layer directly contacts an upper surface of the encapsulation layer in the display area, and does not overlap the encapsulation layer in the dam area in a plan view; and a color filter layer disposed in the display area on the organic protective layer, where the color filter layer directly contacts an upper surface of the organic protective layer in the display area, and does not overlap the encapsulation layer in the dam area in the plan view.

A display device according to embodiments of the disclosure may include an organic protective layer disposed between an encapsulation layer and a color filter layer in a display area. In such embodiments, the color filter layer may be spaced apart from the encapsulation layer with the organic protective layer interposed therebetween. In such embodiments, the color filter layer may directly contact an upper surface of the organic protective layer. In such embodiments, as the organic protective layer includes an organic material, when forming the color filter layer on the upper surface of the organic protective layer, a problem of color filters included in the color filter layer falling off may be effectively prevented. Accordingly, the display quality of the display device may be improved.

A display device according to embodiments of the disclosure may include a dam portion disposed in a dam area surrounding the display area, the encapsulation layer disposed on the dam portion in the dam area, and the organic protective layer which does not overlap the encapsulation layer in the dam area in a plan view. In such embodiments, the organic protective layer may not be disposed in the dam area on the encapsulation layer. Accordingly, crack defect in the encapsulation layer that may occur during the process of forming the organic protective layer on the upper surface of the encapsulation layer in the dam area may be effectively prevented. As a result, the reliability of the encapsulation layer may be improved.

### BRIEF DESCRIPTION OF THE DRAWINGS

Illustrative, non-limiting embodiments will be more clearly understood from the following detailed description in conjunction with the accompanying drawings.
FIG. 1 is a plan view illustrating a display device according to an embodiment of the disclosure.
FIG. 2 is an enlarged plan view of area A of FIG. 1.
FIG. 3 is a cross-sectional view taken along line II-II' of FIG. 2.
FIG. 4 is a cross-sectional view taken along line I-I' of FIG. 1.
FIG. 5 is a plan view illustrating an area where an organic protective layer included in the display device of FIG. 3 is disposed.
FIG. 6 is a cross-sectional view taken along line III-III' of FIG. 5.
FIG. 7 is a cross-sectional view taken along line IV-IV' of FIG. 5.
FIG. 8 is a block diagram illustrating an electronic device according to an embodiment of the present disclosure.
FIG. 9 is a view illustrating an example in which the electronic device of FIG. 8 is implemented as a smart phone.
FIG. 10 is a view illustrating an example in which the electronic device of FIG. 8 is implemented as a head mounted display device.

### DETAILED DESCRIPTION

The invention now will be described more fully hereinafter with reference to the accompanying drawings, in which various embodiments are shown. This invention may, however, be embodied in many different forms, and should not be construed as limited to the embodiments set forth herein. Rather, these embodiments are provided so that this disclosure will be thorough and complete, and will fully convey the scope of the invention to those skilled in the art. Like reference numerals refer to like elements throughout.

It will be understood that when an element is referred to as being "on" another element, it can be directly on the other element or intervening elements may be present therebetween. In contrast, when an element is referred to as being "directly on" another element, there are no intervening elements present.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. Thus, reference to "an" element in a claim followed by reference to "the" element is inclusive of one element and a plurality of the elements. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Hereinafter, embodiments of the disclosure will be described in detail with reference to the accompanying drawings. The same reference numerals are used for the same components in the drawings, and any repetitive detailed descriptions of the same components will be omitted or simplified.

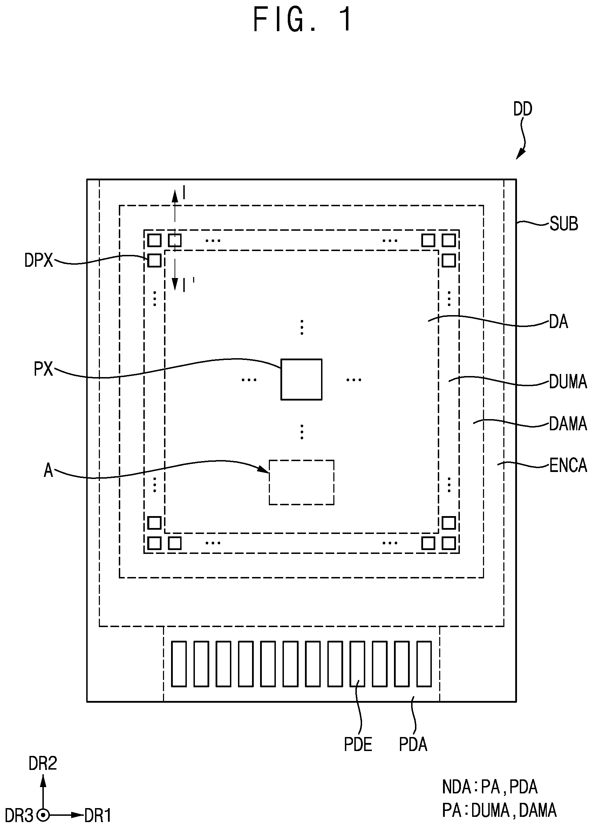

FIG. 1 is a plan view illustrating a display device according to an embodiment of the disclosure.

In the disclosure, a plane may be defined by a first direction DR1 and a second direction DR2 intersecting the first direction DR1. For example, the first direction DR1 and the second direction DR2 may be perpendicular to each other. A direction normal to the plane, that is, a thickness direction of a display device DD may be a third direction DR3. In other words, the third direction DR3 may be perpendicular to each of the first direction DR1 and the second direction DR2. As used herein the "plan view" is a view in the third direction DR3.

Referring to FIG. 1, the display device DD according to an embodiment of the disclosure may include a substrate SUB, a plurality of pixels PX, a plurality of dummy pixels DPX, and a plurality of pad electrodes PDE.

The substrate SUB may include (or be divided into) a display area DA and a non-display area NDA. The display area DA may be defined as an area that displays an image by generating light or adjusting the transmittance of light provided from an external light source. The pixels PX may be disposed in the display area DA. Each of the pixels PX may generate light in response to a driving signal. In an embodiment, for example, the pixels PX may be disposed in a matrix form along the first direction DR1 and the second direction DR2.

The non-display area NDA may be defined as an area that does not display an image. Drivers for displaying an image in the display area DA may be disposed in the non-display area NDA. The non-display area NDA may include a peripheral area PA and a pad area PDA.

The peripheral area PA may be positioned around a periphery of the display area DA. The peripheral area PA may surround at least a portion of the display area DA. In an embodiment, for example, the peripheral area PA may entirely surround the display area DA in a plan view (or when viewed in the third direction DR3). The peripheral area PA may include a dummy pixel area DUMA and a dam area DAMA.

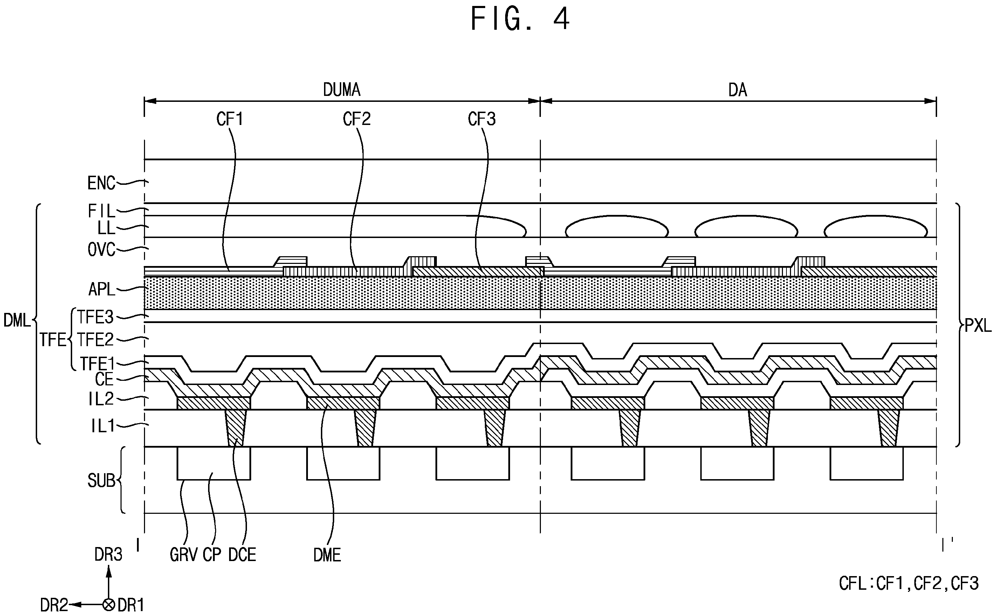

The dummy pixel area DUMA may surround the display area DA. In an embodiment, for example, the dummy pixel area DUMA may entirely surround the display area DA. The dummy pixel area DUMA may be formed in consideration of process deviations that may occur in the manufacturing process of the display device DD. In other words, the dummy pixel area DUMA may be formed to entirely surround the pixels PX and may serve as a buffer area. The dummy pixels DPX may be disposed in the dummy pixel area DUMA. The dummy pixels DPX may be disposed repeatedly along a border of the dummy pixel area DUMA. The dummy pixels DPX may include patterns that is substantially the same as or similar to contact holes and electrodes included in the pixels PX. A detailed features thereof will be described below with reference to FIG. 4.

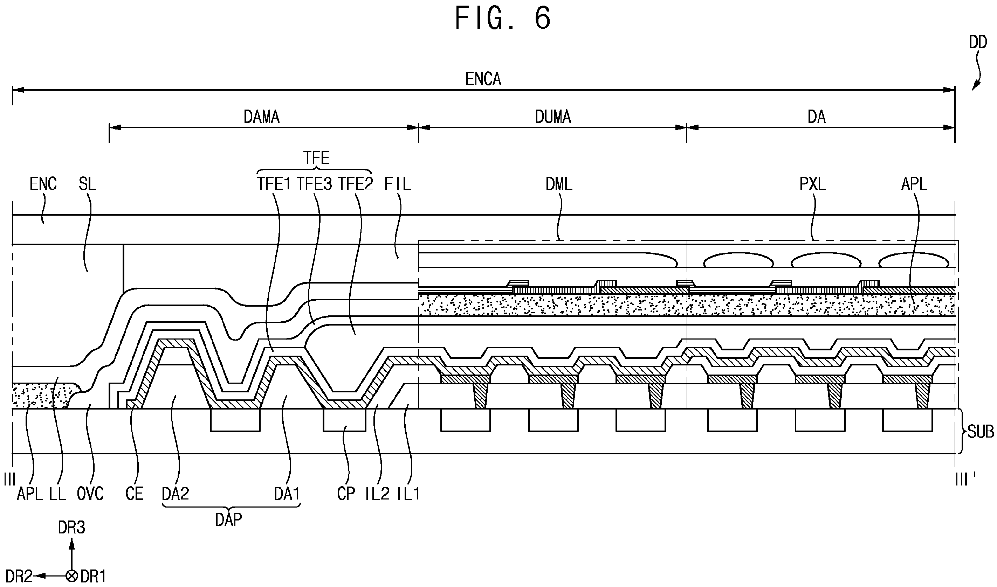

The dam area DAMA may surround the display area DA and the dummy pixel area DUMA. In an embodiment, for example, the dam area DAMA may entirely surround the display area DA and the dummy pixel area DUMA. In addition, the dam area DAMA may be disposed between the dummy pixel area DUMA and the pad area PDA. A dam portion (DAP, refer to FIG. 6) may be disposed in the dam area DAMA on the substrate SUB. The dam portion may effectively prevent an organic encapsulation layer (TFE2, refer to FIG. 6) from overflowing onto circuit elements positioned on an outer portion of the dam portion adjacent to an edge of the substrate SUB.

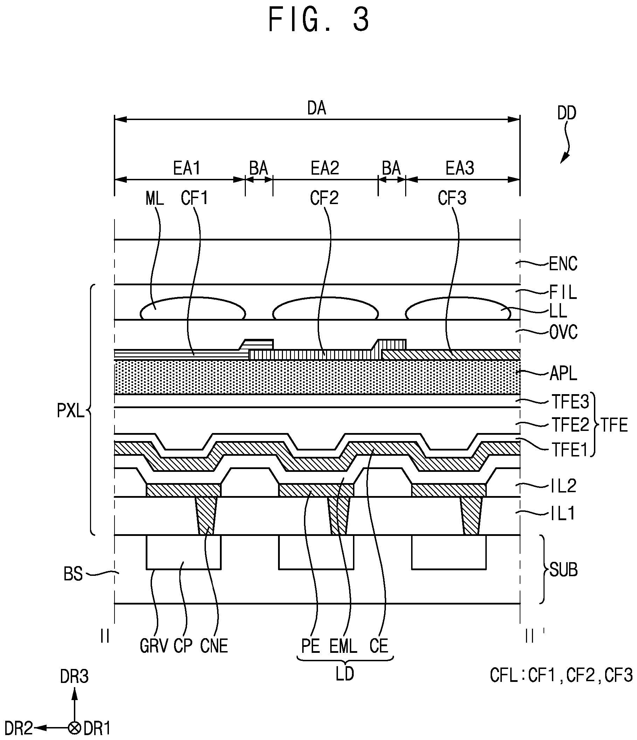

An encapsulation substrate area ENCA may be defined as an area where an encapsulation substrate (ENC, refer to FIG. 3) is disposed. The encapsulation substrate area ENCA may entirely overlap the display area DA, the dummy pixel area DUMA, and the dam area DAMA in a plan view.

The pad area PDA may be spaced apart from the dam area DAMA in one direction, e.g., in the second direction DR2. In an embodiment, for example, the pad area PDA may be spaced apart from the dam area DAMA in the second direction DR2. The pad electrodes PDE may be disposed in the pad areas PDA on the substrate SUB. Although not illustrated in FIG. 1, a printed circuit board may be disposed in the pad area PDA on the substrate SUB. The printed circuit board may be connected to the pad electrodes PDE through an anisotropic conductive film. In an embodiment, for example, the printed circuit board may be a flexible printed circuit board.

The display device DD according to an embodiment of the disclosure may be a display device that displays an image. In an embodiment, for example, the display device DD may be an organic light emitting diode display device, a liquid crystal display device, or a display device including an organic light emitting diode on silicon ("OLEDoS"), a liquid crystal on silicon ("LCoS"), or a light emitting diode on silicon ("LEDoS"). In an embodiment, the display device DD may be a display device including an OLEDoS, that is, an OLEDoS display device.

In an embodiment, for example, where the display device DD is a display device including OLEDoS, the display device DD may configure a head mounted display, which is a glasses-type monitor device for virtual reality or augmented reality that is worn in the form of glasses, helmets, etc. and focuses on a close distance in front of the user's eyes. However, the disclosure is not limited thereto, and the display device DD may configure various displays.

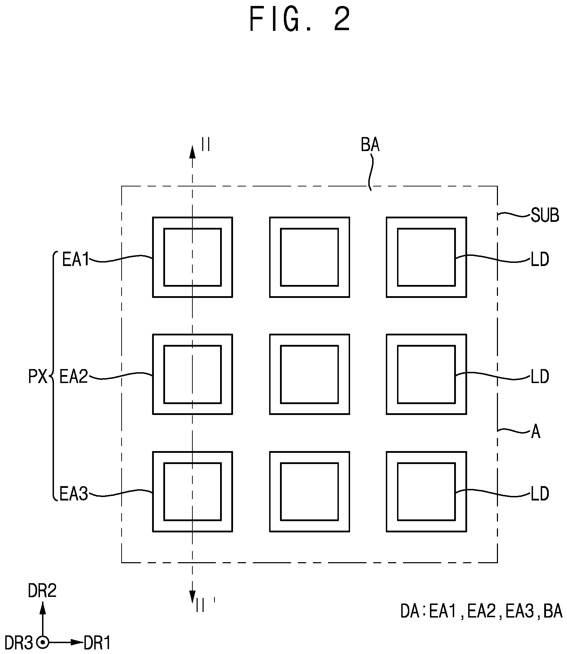

FIG. 2 is an enlarged plan view of area A of FIG. 1.

Referring to FIG. 2, in an embodiment, the substrate SUB may include the display area DA, and the display area DA may include a first light emitting area EA1, a second light emitting area EA2, a third light emitting area EA3, and a light blocking area BA. Each of the pixels PX may include the first light emitting area EA1, the second light emitting area EA2, and the third light emitting area EA3 that emit light. Although FIG. 2 illustrates an embodiment where each of the pixels PX includes three light emitting areas EA1, EA2, EA3, the disclosure is not limited thereto. In another embodiment, for example, each of the pixels PX may include four or more light emitting areas.

In an embodiment, for example, each of the first light emitting area EA1, the second light emitting area EA2, and the third light emitting area EA3 may have a triangular planar shape, a rectangular planar shape, a circular planar shape, an oval planar shape, etc. In an embodiment, each of the first light emitting area EA1, the second light emitting area EA2, and the third light emitting area EA3 may have a rectangular planar shape. Each of the first light emitting area EA1, the second light emitting area EA2, and the third light emitting area EA3 may have a same size and/or shape as each other. However, the disclosure is not limited thereto, and each of the first light emitting area EA1, the second light emitting area EA2, and the third light emitting area EA3 may have different planar shapes. In an embodiment, for example, each of the first light emitting area EA1, the second light emitting area EA2, and the third light emitting area EA3 may have different sizes and/or shapes.

Each of the first light emitting area EA1, the second light emitting area EA2, and the third light emitting area EA3 may include a light emitting element LD that emits first light. In an embodiment, for example, the first light may be white light. However, the disclosure is not limited thereto, and the light emitting element LD included in the first light emitting area EA1 may emit blue light, the light emitting element LD included in the second light emitting area EA2 may emit green light, and the light emitting element LD included in the third light emitting area EA3 may emit red light. In an embodiment, the light emitting element LD may be a micro organic light emitting diode. However, the disclosure is not limited thereto.

The first light emitting area EA1 may emit second light. The first light emitting area EA1 may convert the first light emitted from the light emitting element LD into the second light and may emit the second light. In an embodiment, for example, the second light may be blue light, but the disclosure is not limited thereto.

The second light emitting area EA2 may emit third light. The second light emitting area EA2 may convert the first light emitted from the light emitting element LD into the third light and may emit the third light. In an embodiment, for example, the third light may be green light, but the disclosure is not limited thereto.

The third light emitting area EA3 may emit fourth light. The third light emitting area EA3 may convert the first light emitted from the light emitting element LD into the fourth light and may emit the fourth light. In an embodiment, for example, the fourth light may be red light, but the disclosure is not limited thereto.

The first light emitting area EA1, the second light emitting area EA2, and the third light emitting area EA3 may be arranged along the second direction DR2. In an embodiment, for example, the first light emitting area EA1, the second light emitting area EA2, and the third light emitting area EA3 may be arranged along the second direction DR2 in an order of the third light emitting area EA3, the second light emitting area EA2, and the first light emitting area EA1. In addition, the first light emitting area EA1, the second light emitting area EA2, and the third light emitting area EA3 may be arranged along the first direction DR1. However, the arrangement structure of the first to third light emitting areas EA1, EA2, EA3 is not limited thereto.

The light blocking area BA may be disposed between the first to third light emitting areas EA1, EA2, EA3. In an embodiment, for example, the light blocking area BA may surround the first to third light emitting areas EA1, EA2, EA3 in a plan view. In an embodiment, for example, the light blocking area BA may have a mesh shape, a net shape, a lattice shape, etc. in a plan view. The light blocking area BA may be defined as an area that blocks light.

FIG. 3 is a cross-sectional view taken along line II-II' of FIG. 2. Particularly, FIG. 3 is a cross-sectional view illustrating the display area DA of FIG. 1.

Referring to FIG. 3, the display device DD according to an embodiment of the disclosure may include the substrate SUB, a display layer PXL, and an encapsulation substrate ENC in the display area DA.

The substrate SUB may include a base substrate BS and a plurality of circuit portions CP. In an embodiment, the substrate SUB may be a semiconductor circuit board. The substrate SUB may include a silicon wafer.

The base substrate BS may define a plurality of grooves GRV. The circuit portions CP may be accommodated in the grooves GRV, respectively. Each of the circuit portions CP may include at least one transistor and at least one capacitor.

The display layer PXL may be disposed on the substrate SUB. The display layer PXL may include a first insulating layer IL1, a connection electrode CNE, a second insulating layer IL2, the light emitting elements LD, an encapsulation layer TFE, an organic protective layer APL, a color filter layer CFL, a flattening layer OVC, a lens layer LL, and a filling layer FIL. Each of the light emitting elements LD may include a pixel electrode PE, a light emitting layer EML, and a common electrode CE.

The first insulating layer IL1 may be disposed on the substrate SUB. A contact hole may be defined in the first insulating layer IL1. The contact hole may expose a portion of the circuit portion CP. The first insulating layer IL1 may include an inorganic insulating material and/or an organic insulating material. Examples of the inorganic insulating material that may be used as the first insulating layer IL1 may include silicon oxide (SiOₓ), silicon nitride (SiNₓ), silicon oxynitride (SiOₓN_{y}), etc. These may be used alone or in combination with each other. Examples of the organic insulating material that may be used as the first insulating layer IL1 may include a photoresist, a polyacryl-based resin, a polyimide-based resin, a polyamide-based resin, a siloxane-based resin, an acryl-based resin, an epoxy-based resin, etc. They may be used alone or in combination with each other.

The connection electrode CNE may be disposed on the substrate SUB. In an embodiment, for example, the connection electrode CNE may be disposed in the contact hole defined by the first insulating layer IL1. The connection electrode CNE may be connected to the circuit portion CP. The connection electrode CNE may electrically connect the circuit portion CP and the pixel electrode PE to each other. The connection electrode CNE may include a metal, an alloy, a metal nitride, a conductive metal oxide, a transparent conductive material, etc. Examples of materials that may be used as the connection electrode CNE may include silver (Ag), an alloy including silver, molybdenum (Mo), an alloy including molybdenum, aluminum (Al), an alloy including aluminum, aluminum nitride (AIN), tungsten (W), tungsten nitride (WN), copper (Cu), nickel (Ni), chromium (Cr), chromium nitride (CrN), titanium (Ti), tantalum (Ta), platinum (Pt), scandium (Sc), indium tin oxide (ITO), indium zinc oxide (IZO), etc. These may be used alone or in combination with each other.

The pixel electrode PE may be disposed on the first insulating layer IL1 and the connection electrode CNE. The pixel electrode PE may overlap each of the first to third light emitting areas EA1, EA2, EA3 in a plan view. The pixel electrode PE may be connected to the circuit portion CP through the connection electrode CNE. The pixel electrode PE may include a metal, an alloy, a metal nitride, a conductive metal oxide, a transparent conductive material, etc. They may be used alone or in combination with each other. In an embodiment, for example, the pixel electrode PE may serve as an anode electrode.

The second insulating layer IL2 may be disposed on the first insulating layer IL1 and the pixel electrode PE. The second insulating layer IL2 may cover an edge of the pixel electrode PE and define an opening exposing an upper surface of the pixel electrode PE. The second insulating layer IL2 may include an organic insulating material. Examples of the organic insulating material that may be used as the second insulating layer IL2 may include a photoresist, a polyacryl-based resin, a polyimide-based resin, a polyamide-based resin, a siloxane-based resin, an acryl-based resin, an epoxy-based resin, etc. They may be used alone or in combination with each other.

The light emitting layer EML may be disposed on the pixel electrode PE and the second insulating layer IL2. In an embodiment, the light emitting layer EML may continuously extend along the first to third light emitting areas EA1, EA2, EA3. However, the disclosure is not limited thereto, and the light emitting layer EML may be independently disposed in each of the first to third light emitting areas EA1, EA2, EA3. The light emitting layer EML may include an organic material that emits light of a predetermined color. In an embodiment, the light emitting layer EML may include an organic light emitting material that emits white light.

The common electrode CE may be disposed on the light emitting layer EML. The common electrode CE may continuously extend along the first to third light emitting areas EA1, EA2, EA3. The common electrode CE may include a metal, an alloy, a metal nitride, a conductive metal oxide, a transparent conductive material, etc. These may be used alone or in combination with each other. In an embodiment, for example, the common electrode CE may serve as a cathode electrode.

Accordingly, the light emitting elements LD each including the pixel electrode PE, the light emitting layer EML, and the common electrode CE may be provided in the display layer PXL.

The encapsulation layer TFE may be disposed on the light emitting layer EML in the display area DA. In an embodiment, for example, the encapsulation layer TFE may be disposed on the common electrode CE. The encapsulation layer TFE may effectively prevent impurities, moisture, etc. from penetrating into the light emitting element LD from the outside. The encapsulation layer TFE may include at least one inorganic encapsulation layer and at least one organic encapsulation layer. In an embodiment, for example, the inorganic encapsulation layer may include silicon oxide (SiOₓ), silicon nitride (SiNₓ), silicon oxynitride (SiOₓN_{y}), etc. These may be used alone or in combination with each other. In an embodiment, for example, the organic encapsulation layer may include a polymer cured material such as polyacrylate. In an embodiment, the encapsulation layer TFE may include a first inorganic encapsulation layer TFE1, an organic encapsulation layer TFE2, and a second inorganic encapsulation layer TFE3. The first inorganic encapsulation layer TFE1, the organic encapsulation layer TFE2, and the second inorganic encapsulation layer TFE3 may be sequentially stacked along the third direction DR3.

The first inorganic encapsulation layer TFE1 may be disposed on the common electrode CE. The first inorganic encapsulation layer TFE1 may cover the common electrode CE and may be disposed along the profile of the common electrode CE with a uniform thickness. The first inorganic encapsulation layer TFE1 may effectively prevent the light emitting element LD from being deteriorated due to penetration of impurities, moisture, etc. In addition, the first inorganic encapsulation layer TFE1 may protect the light emitting element LD from external impact. In an embodiment, for example, the first inorganic encapsulation layer TFE1 may include a flexible inorganic insulating material.

The organic encapsulation layer TFE2 may be disposed on the first inorganic encapsulation layer TFE1. The organic encapsulation layer TFE2 may compensate for a step difference of (or provide a flat surface on) the first inorganic encapsulation layer TFE1. Accordingly, the organic encapsulation layer TFE2 may have a substantially flat upper surface in the display area DA. The organic encapsulation layer TFE2 may protect the light emitting element LD together with the first inorganic encapsulation layer TFE1. In an embodiment, for example, the organic encapsulation layer TFE2 may include a flexible organic material.

The second inorganic encapsulation layer TFE3 may be disposed on the organic encapsulation layer TFE2. The second inorganic encapsulation layer TFE3 may prevent the light emitting element LD from being deteriorated by penetration of impurities, moisture, etc., together with the first inorganic encapsulation layer TFE1. In addition, the second inorganic encapsulation layer TFE3 may protect the light emitting element LD from external impact together with the first inorganic encapsulation layer TFE1 and the organic encapsulation layer TFE2. In an embodiment, for example, the second inorganic encapsulation layer TFE3 may include a flexible inorganic insulating material.

In an alternative embodiment, the encapsulation layer TFE may have a five-layer structure including a first inorganic encapsulation layer, a first organic encapsulation layer, a second inorganic encapsulation layer, a second organic encapsulation layer, and a third inorganic encapsulation layer which are sequentially stacked along the third direction DR3. In an alternative embodiment, the encapsulation layer TFE may have a seven-layer structure including a first inorganic encapsulation layer, a first organic encapsulation layer, a second inorganic encapsulation layer, a second organic encapsulation layer, a third inorganic encapsulation layer, a third organic encapsulation layer, and a fourth inorganic encapsulation layer which are sequentially stacked along the third direction DR3.

The organic protective layer APL may be disposed on the encapsulation layer TFE in the display area DA. In an embodiment, for example, the organic protective layer APL may be disposed between the encapsulation layer TFE and the color filter layer CFL. The organic protective layer APL may directly contact an upper surface of the encapsulation layer TFE in the display area DA, and the color filter layer CFL may directly contact an upper surface of the organic protective layer APL. Accordingly, the color filter layer CFL may be spaced apart from the encapsulation layer TFE with the organic protective layer APL interposed therebetween. The organic protective layer APL may include an organic material. Examples of the organic material that may be used as the organic protective layer APL may include photoresist, polyacryl-based resin, polyimide-based resin, polyamide-based resin, siloxane-based resin, acryl-based resin, epoxy-based resin, etc. They may be used alone or in combination with each other. In an embodiment, for example, a thickness (or, a length in the third direction DR3) of the organic protective layer APL may be about 40 micrometers, but the disclosure is not limited thereto.

In a conventional display device, when the color filter layer CFL is formed on the upper surface of the encapsulation layer TFE without the organic protective layer APL, a problem of color filters including in the color filter layer CFL falling off may occur. Specifically, in a case where the color filter layer CFL is formed on the second inorganic encapsulation layer TFE3 including an inorganic insulating material, the color filters including an organic material may fall off.

The display device DD according to an embodiment of the disclosure may include the organic protective layer APL disposed between the encapsulation layer TFE and the color filter layer CFL in the display area DA. In such an embodiment, the organic protective layer APL may directly contact the upper surface of the encapsulation layer TFE, and the color filter layer CFL may directly contact the upper surface of the organic protective layer APL. In such an embodiment where the organic protective layer APL includes an organic material, the problem of the color filters falling off when forming the color filter layer CFL on the upper surface of the organic protective layer APL may be effectively prevented. Accordingly, the display quality of the display device DD may be improved.

The color filter layer CFL may be disposed on the organic protective layer APL. In addition, the color filter layer CFL may directly contact the upper surface of the organic protective layer APL. The color filter layer CFL may include a first color filter CF1, a second color filter CF2, and a third color filter CF3 that transmit light of different colors.

The first color filter CF1 may be disposed in the first light emitting area EA1 on the organic protective layer APL. The first color filter CF1 may transmit the second light and may absorb or block the third light and the fourth light among the first light emitted from the light emitting layer EML. In an embodiment, for example, the first color filter CF1 may transmit blue light and may absorb or block green light and red light. However, the disclosure is not limited thereto.

The second color filter CF2 may be disposed in the second light emitting area EA2 on the organic protective layer APL. The second color filter CF2 may transmit the third light and may absorb or block the second light and the fourth light among the first light emitted from the light emitting layer EML. In an embodiment, for example, the second color filter CF2 may transmit green light and may absorb or block red light and blue light. However, the disclosure is not limited thereto.

The third color filter CF3 may be disposed in the third light emitting area EA3 on the organic protective layer APL. The third color filter CF3 may transmit the fourth light and may absorb or block the second light and the third light among the first light emitted from the light emitting layer EML. In an embodiment, for example, the third color filter CF3 may transmit red light and may absorb or block green light and blue light. However, the disclosure is not limited thereto.

The first color filter CF1 and the second color filter CF2 may overlap each other in the light blocking area BA positioned between the first light emitting area EA1 and the second light emitting area EA2. In addition, the second color filter CF2 and the third color filter CF3 may overlap each other in the light blocking area BA positioned between the second light emitting area EA2 and the third light emitting area EA3. In addition, although not illustrated in FIG. 3, the first color filter CF1 and the third color filter CF3 may overlap each other in the light blocking area BA positioned between the first light emitting area EA1 and the third light emitting area EA3. That is, a portion where the different color filters overlap each other may overlap the light blocking area BA in a plan view or in the third direction DR3. The portion where the different color filters overlap each other may serve as a light blocking pattern that blocks light. In an alternative embodiment, the color filter layer CFL may include a black matrix pattern that overlaps the light blocking area BA in a plan view and includes an organic material including a light blocking material. In an embodiment, for example, the light blocking material may include black pigment, black dye, carbon black, etc.

The flattening layer OVC may be disposed on the color filter layer CFL in the display area DA. The flattening layer OVC may be entirely disposed over the first to third light emitting areas EA1, EA2, EA3 and the light blocking area BA. The flattening layer OVC may flatten a step difference of the color filter layer CFL. The flattening layer OVC may include an organic insulating material.

The lens layer LL may be disposed on the flattening layer OVC in the display area DA. The lens layer LL may include a plurality of micro lenses ML in the display area DA. The micro lenses ML may overlap each of the first light emitting area EA1, the second light emitting area EA2, and the third light emitting area EA3 in a plan view. In addition, the micro lenses ML may overlap each of the first color filter CF1 , the second color filter CF2 and the third color filter CF3 in a plan view. The micro lenses ML may improve light extraction efficiency. The micro lenses ML may have a predetermined refractive index. In an embodiment, for example, the micro lenses ML may have a refractive index greater than or equal to about 1.5 and less than or equal to about 1.7, but the disclosure is not limited thereto.

The filling layer FIL may be disposed on the lens layer LL. The filling layer FIL may flatten a step difference of the lens layer LL. The filling layer FIL may include an inorganic insulating material or an organic insulating material.

The encapsulation substrate ENC may be disposed on the filling layer FIL. The encapsulation substrate ENC may serve to cover and protect the display layer PXL. The encapsulation substrate ENC may include a transparent material. In an embodiment, for example, the encapsulation substrate ENC may include glass or plastic.

FIG. 4 is a cross-sectional view taken along line I-I' of FIG. 1. Particularly, FIG. 4 is a cross-sectional view illustrating the display area DA and the dummy pixel area DUMA of FIG. 1. Hereinafter, any repetitive detailed descriptions of the same or like elements as those in the display area DA described above with reference to FIG. 3 may be omitted or simplified.

Referring to FIG. 4, the display device DD according to an embodiment of the disclosure may include the substrate SUB, a dummy layer DML, and the encapsulation substrate ENC in the dummy pixel area DUMA.

The dummy layer DML may be disposed on the substrate SUB in the dummy pixel area DUMA. The dummy layer DML may include the first insulating layer IL1, a dummy connection electrode DCE, the second insulating layer IL2, a dummy electrode DME, the common electrode CE, the encapsulation layer TFE, the organic protective layer APL, the color filter layer CFL, the flattening layer OVC, the lens layer LL, and the filling layer FIL.

The first insulating layer IL1 may be disposed on the substrate SUB. A contact hole exposing a portion of the circuit portion CP may be defined in the first insulating layer IL1.

The dummy connection electrode DCE may be disposed on the substrate SUB. In an embodiment, the dummy connection electrode DCE may be disposed in the contact hole defined by the first insulating layer IL1. The dummy connection electrode DCE may be connected to the circuit portion CP. The dummy connection electrode DCE disposed in the dummy pixel area DUMA and the connection electrode (CNE, refer to FIG. 3) disposed in the display area DA may receive different signals, respectively. The dummy connection electrode DCE may electrically connect the circuit portion CP and the dummy electrode DME to each other. The dummy connection electrode DCE may include a metal, an alloy, a metal nitride, a conductive metal oxide, a transparent conductive material, etc. They may be used alone or in combination with each other. The dummy connection electrode DCE may be formed through a same process and may include a same material as the connection electrode disposed in the display area DA.

The dummy electrode DME may be disposed on the substrate SUB in the dummy pixel area DUMA. In an embodiment, the dummy electrode DME may be disposed on the first insulating layer IL1 and the dummy connection electrode DCE. The dummy electrode DME may be connected to the circuit portion CP through the dummy connection electrode DCE. The dummy electrode DME may include a metal, an alloy, a metal nitride, a conductive metal oxide, a transparent conductive material, etc. They may be used alone or in combination with each other. The dummy electrode DME may be formed through a same process and may include a same material as the pixel electrode (PE, refer to FIG. 3) disposed in the display area DA.

The second insulating layer IL2 may be disposed on the first insulating layer IL1 and the dummy electrode DME. The second insulating layer IL2 may cover an edge of the dummy electrode DME and define (or be provided with) an opening exposing an upper surface of the dummy electrode DME.

The light emitting layer (EML, refer to FIG. 3) may be spaced apart from the dummy pixel area DUMA in a plan view. In such an embodiment, the light emitting layer may not be disposed in the dummy pixel area DUMA. Accordingly, the dummy pixel area DUMA may not display an image.

The common electrode CE may be disposed on the second insulating layer IL2 and the dummy electrode DME in the dummy pixel area DUMA. The common electrode CE may continuously extend along the display area DA and the dummy pixel area DUMA.

The encapsulation layer TFE may be disposed on the dummy electrode DME in the dummy pixel area DUMA. In an embodiment, the encapsulation layer TFE may be disposed on the common electrode CE in the display area DA and the dummy pixel area DUMA. The encapsulation layer TFE may include the first inorganic encapsulation layer TFE1, the organic encapsulation layer TFE2, and the second inorganic encapsulation layer TFE3.

The first inorganic encapsulation layer TFE1 may be disposed on the common electrode CE. The first inorganic encapsulation layer TFE1 may continuously extend along the display area DA and the dummy pixel area DUMA. A level of an upper surface of the first inorganic encapsulation layer TFE1 in the display area DA may be different from a level of the upper surface of the first inorganic encapsulation layer TFE1 in the dummy pixel area DUMA. In an embodiment, for example, the level (i.e., a distance in the third direction DR3 from the substrate SUB) of the upper surface of the first inorganic encapsulation layer TFE1 in the display area DA may be greater than the level of the upper surface of the first inorganic encapsulation layer TFE1 in the dummy pixel area DUMA.

The organic encapsulation layer TFE2 may be disposed on the first inorganic encapsulation layer TFE1. The organic encapsulation layer TFE2 may compensate for a step difference of the first inorganic encapsulation layer TFE1. In addition, the organic encapsulation layer TFE2 may compensate for a level difference between the upper surface of the first inorganic encapsulation layer TFE1 in the display area DA and the upper surface of the first inorganic encapsulation layer TFE1 in the dummy pixel area DUMA.

The second inorganic encapsulation layer TFE3 may be disposed on the organic encapsulation layer TFE2. A level of an upper surface of the second inorganic encapsulation layer TFE3 in the display area DA may be substantially the same as a level of the upper surface of the second inorganic encapsulation layer TFE3 in the dummy pixel area DUMA.

The organic protective layer APL may be disposed on the encapsulation layer TFE in the display area DA and the dummy pixel area DUMA. In an embodiment, the organic protective layer APL may be disposed between the encapsulation layer TFE and the color filter layer CFL in the display area DA and the dummy pixel area DUMA. The organic protective layer APL may directly contact the upper surface of the encapsulation layer TFE in the display area DA and the dummy pixel area DUMA. The dummy pixel area DUMA may be formed in consideration of process deviations that may occur in the manufacturing process of the display device DD. In such an embodiment, the dummy pixel area DUMA may serve as a buffer area. To serve as the buffer area, the organic protective layer APL may also be disposed in the dummy pixel area DUMA. A thickness (or, a length in the third direction DR3) of the organic protective layer APL may be substantially the same in the display area DA and the dummy pixel area DUMA. In an alternative embodiment, the organic protective layer APL may be disposed only in the display area DA and may not be disposed in the dummy pixel area DUMA.

The color filter layer CFL may be disposed on the organic protective layer APL in the display area DA and the dummy pixel area DUMA. The color filter layer CFL may directly contact the upper surface of the organic protective layer APL in the display area DA and the dummy pixel area DUMA. The flattening layer OVC may be disposed on the color filter layer CFL in the display area DA and the dummy pixel area DUMA. In an embodiment, a level of an upper surface of the flattening layer OVC in the display area DA may be substantially the same as a level of the upper surface of the flattening layer OVC in the dummy pixel area DUMA.

The lens layer LL may be disposed on the flattening layer OVC in the display area DA and the dummy pixel area DUMA. The lens layer LL may include the micro lenses (ML, refer to FIG. 3) in the display area DA. In an embodiment, the micro lenses ML may be spaced apart from the dummy pixel area DUMA in a plan view. In such an embodiment, the micro lenses ML may not be formed in the dummy pixel area DUMA.

The filling layer FIL may be disposed on the lens layer LL in the display area DA and the dummy pixel area DUMA. The encapsulation substrate ENC may be disposed on the filling layer FIL in the display area DA and the dummy pixel area DUMA.

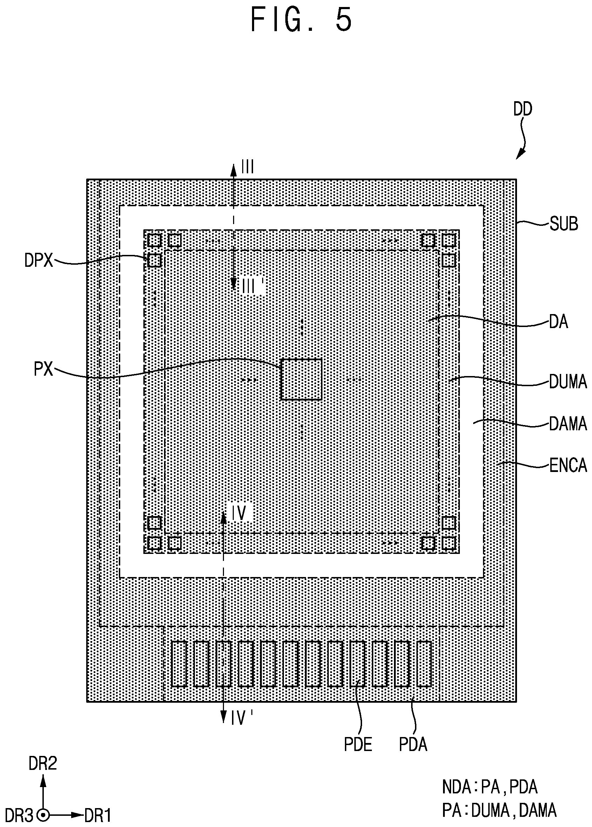

FIG. 5 is a plan view illustrating an area where an organic protective layer included in the display device of FIG.3 is disposed.

Referring to FIG. 5, the display device DD according to an embodiment of the disclosure may include the substrate SUB, the pixels PX, the dummy pixels DPX, the pad electrodes PDE, and the organic protective layer APL. The substrate SUB may include the display area DA and the non-display area NDA. The non-display area NDA may include the peripheral area PA and the pad area PDA. The peripheral area PA may include the dummy pixel area DUMA and the dam area DAMA.

In a plan view (or when viewed in the third direction DR3), the organic protective layer APL may be disposed in the display area DA, the dummy pixel area DUMA, and the pad area PDA, and the organic protective layer APL may not be disposed in the dam area DAMA. In an embodiment, the organic protective layer APL may be disposed in an entire area of the substrate SUB excluding the dam area DAMA. In such an embodiment, the organic protective layer APL may be disposed in a hatched area of FIG. 5.

FIG. 6 is a cross-sectional view taken along line III-III' of FIG. 5. Particularly, FIG. 6 is a cross-sectional view illustrating the display area DA, the dummy pixel area DUMA, and the dam area DAMA of FIG. 5. Hereinafter, any repetitive detailed descriptions of the same or like elements as those in the display area DA and the dummy pixel area DUMA described above with reference to FIGS. 3 and 4 may be omitted or simplified.

Referring to FIG. 6, the display device DD according to an embodiment of the disclosure may include the substrate SUB, the first insulating layer IL1, the second insulating layer IL2, a dam portion DAP, the common electrode CE, the encapsulation layer TFE, the flattening layer OVC, the lens layer LL, a sealing member SL, and the filling layer FIL in the dam area DAMA. The encapsulation layer TFE may include the first inorganic encapsulation layer TFE1, the organic encapsulation layer TFE2, and the second inorganic encapsulation layer TFE3. A boundary of the dam area DAMA with an outer portion of the dam portion DAP adjacent to the edge of the substrate SUB may be defined as an end of the encapsulation layer TFE extending toward an edge of the substrate SUB. In an embodiment, the boundary of the dam area DAMA may be defined as an end of the second inorganic encapsulation layer TFE3 extending toward the edge of the substrate SUB.

The dam portion DAP may be disposed on the substrate SUB in the dam area DAMA. The dam portion DAP may include an inorganic insulating material and/or an organic insulating material. The dam portion DAP may effectively prevent the organic encapsulation layer TFE2 from overflowing onto circuit elements positioned on the outer portion of the dam portion DAP adjacent to the edge of the substrate SUB.

The dam portion DAP may include a plurality of dams. Each of the dams may have a single-layer structure or a multi-layer structure. In an embodiment, for example, the dam portion DAP may include a first dam DA1 having a single-layer structure and a second dam DA2 spaced apart from the first dam DA1 and having a multi-layer structure. However, the structure of the dam portion DAP is not limited thereto.

The first dam DA1 may have a single-layer structure. The first dam DA1 may be formed through a same process and may include a same material as the first insulating layer IL1. The second dam DA2 may have a multi-layer structure. In an embodiment, for example, the second dam DA2 may include a first dam layer and a second dam layer disposed on the first dam layer. The first dam layer may be formed through a same process and may include a same material as the first insulating layer IL1. The second dam layer may be formed through a same process and may include a same material as the second insulating layer IL2.

The common electrode CE may be disposed along the profiles of the substrate SUB, the first dam DA1, and the second dam DA2 in the dam area DAMA. The common electrode CE may continuously extend along the display area DA, the dummy pixel area DUMA, and the dam area DAMA.

The first inorganic encapsulation layer TFE1 may be disposed on the dam portion DAP in the dam area DAMA and may cover the dam portion DAP. The first inorganic encapsulation layer TFE1 may be disposed on the common electrode CE. The first inorganic encapsulation layer TFE1 may be disposed along the profile of the common electrode CE. The first inorganic encapsulation layer TFE1 may continuously extend along the display area DA, the dummy pixel area DUMA, and the dam area DAMA.

The organic encapsulation layer TFE2 may be disposed on the first inorganic encapsulation layer TFE1. The organic encapsulation layer TFE2 may not overlap at least a portion of the dam portion DAP (e.g., the second dam DA2) in a plan view. In such an embodiment, the organic encapsulation layer TFE2 may not extend beyond the outer portion of the dam portion DAP. In an embodiment, for example, as illustrated in FIG. 6, the organic encapsulation layer TFE2 may not extend beyond an outer portion of the first dam DA1.

The second inorganic encapsulation layer TFE3 may be disposed on the first inorganic encapsulation layer TFE1. The second inorganic encapsulation layer TFE3 may cover the dam portion DAP and the first inorganic encapsulation layer TFE1. The second inorganic encapsulation layer TFE3 may be disposed along the profiles of the first inorganic encapsulation layer TFE1 and the organic encapsulation layer TFE2. The second inorganic encapsulation layer TFE3 may continuously extend along the display area DA, the dummy pixel area DUMA, and the dam area DAMA.

In an embodiment, the organic protective layer APL may be spaced apart from the dam area DAMA in a plan view. In such an embodiment, the organic protective layer APL may not overlap the encapsulation layer TFE in the dam area DAMA in a plan view. The organic protective layer APL may not be disposed in the dam area DAMA on the encapsulation layer TFE.

In a case where the organic protective layer APL is formed over the entire area of the substrate SUB, a crack defect may occur in the encapsulation layer TFE in the dam area DAMA. In this case, the second inorganic encapsulation layer TFE3 disposed along the profile of a lower structure may have a step difference in the dam area DAMA, and in the process of forming the organic protective layer APL on an upper surface of the second inorganic encapsulation layer TFE3 where the step difference is formed, a crack may occur in the second inorganic encapsulation layer TFE3. In an embodiment, the organic protective layer APL may not be formed in the dam area DAMA to prevent such a crack defect. Accordingly, the reliability of the encapsulation layer TFE may be improved.

In an embodiment, the color filter layer (CFL, refer to FIG. 4) may be spaced apart from the dam area DAMA in a plan view. In such an embodiment, the color filter layer CFL may not overlap the encapsulation layer TFE in the dam area DAMA in a plan view. The color filter layer CFL may not be disposed in the dam area DAMA on the encapsulation layer TFE.

The flattening layer OVC may be disposed on the dam portion DAP in the dam area DAMA. In an embodiment, the flattening layer OVC may be disposed on the encapsulation layer TFE in the dam area DAMA. In an embodiment, the flattening layer OVC may directly contact the upper surface of the second inorganic encapsulation layer TFE3 in the dam area DAMA. The flattening layer OVC may cover the second inorganic encapsulation layer TFE3 in the dam area DAMA. In an embodiment, for example, the flattening layer OVC may extend toward the edge of the substrate SUB beyond the dam area DAMA and may not extend to an end of the encapsulation substrate area ENCA.

In an embodiment, a level of an upper surface of the flattening layer OVC in the display area DA may be different from a level of the upper surface of the flattening layer OVC in the dam area DAMA. In an embodiment, for example, the level of the upper surface of the flattening layer OVC in the display area DA may be greater than the level of the upper surface of the flattening layer OVC in the dam area DAMA.

The lens layer LL may be disposed on the flattening layer OVC in the dam area DAMA. The lens layer LL may cover the flattening layer OVC in the dam area DAMA. The lens layer LL may extend toward the edge of the substrate SUB beyond the dam area DAMA. In such an embodiment, the lens layer LL may extend to the end of the encapsulation substrate area ENCA adjacent to the edge of the substrate SUB.

The lens layer LL may include the micro lenses (ML, refer to FIG. 3) in the display area DA, and the micro lenses ML may be spaced apart from the dam area DAMA in a plan view. In such an embodiment, the micro lenses ML may not be formed in the dam area DAMA.

The filling layer FIL may be disposed on the lens layer LL in the dam area DAMA. The sealing member SL may be disposed on the edge portion of the substrate SUB. The sealing member SL may seal a side surface of the display device DD. The sealing member SL may include an inorganic material. In an embodiment, for example, the sealing member SL may include a glass frit. The encapsulation substrate ENC may be disposed on the filling layer FIL and the sealing member SL.

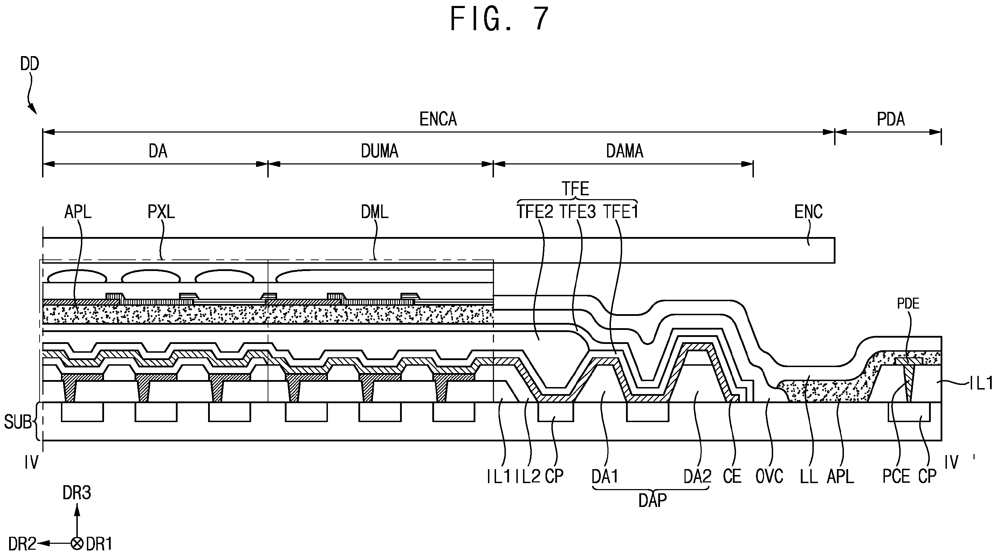

FIG. 7 is a cross-sectional view taken along line IV-IV' of FIG. 5. Particularly, FIG. 7 is a cross-sectional view illustrating the display area DA, the dummy pixel area DUMA, the dam area DAMA, and the pad area PDA of FIG. 5. Hereinafter, any repetitive detailed descriptions of the same or like elements as those in the display area DA, the dummy pixel area DUMA, and the dam area DAMA described above with reference to FIGS. 3, 4, and 6 may be omitted or simplified.

Referring to FIG. 7, the display device DD according to an embodiment of the disclosure may include the substrate SUB, the first insulating layer IL1, a pad connection electrode PCE, the pad electrode PDE, the organic protective layer APL, and the lens layer LL in the pad area PDA.

The first insulating layer IL1 may be disposed on the substrate SUB in the pad area PDA. A contact hole exposing a portion of the circuit portion CP may be defined in the first insulating layer IL1 in the pad area PDA.

The pad connection electrode PCE may be disposed in the contact hole defined by the first insulating layer IL1 in the pad area PDA. The pad connection electrode PCE may be connected to the circuit portion CP. The pad connection electrode PCE may electrically connect the circuit portion CP and the pad electrode PDE to each other. The pad connection electrode PCE may include a metal, an alloy, a metal nitride, a conductive metal oxide, a transparent conductive material, etc. They may be used alone or in combination with each other. The pad connection electrode PCE may be formed through a same process and may include a same material as the connection electrode disposed in the display area DA and the dummy connection electrode disposed in the dummy pixel area DUMA.

The pad electrode PDE may be disposed on the substrate SUB in the pad area PDA. In an embodiment, the pad electrode PDE may be disposed on the first insulating layer IL1 and the pad connection electrode PCE. The pad electrode PDE may be connected to the circuit portion CP through the pad connection electrode PCE. The pad electrode PDE may include a metal, an alloy, a metal nitride, a conductive metal oxide, a transparent conductive material, etc. They may be used alone or in combination with each other. The pad electrode PDE may be formed through a same process and may include a same material as the pixel electrode disposed in the display area DA and the dummy electrode disposed in the dummy pixel area DUMA.

The organic protective layer APL may be disposed on the substrate SUB and the pad electrode PDE in the pad area PDA. In an embodiment, the organic protective layer APL may cover and protect the pad electrode PDE in the pad area PDA.

The lens layer LL may be disposed on the organic protective layer APL in the pad area PDA. The lens layer LL may extend to an end of the pad area PDA adjacent to the edge of the substrate SUB.

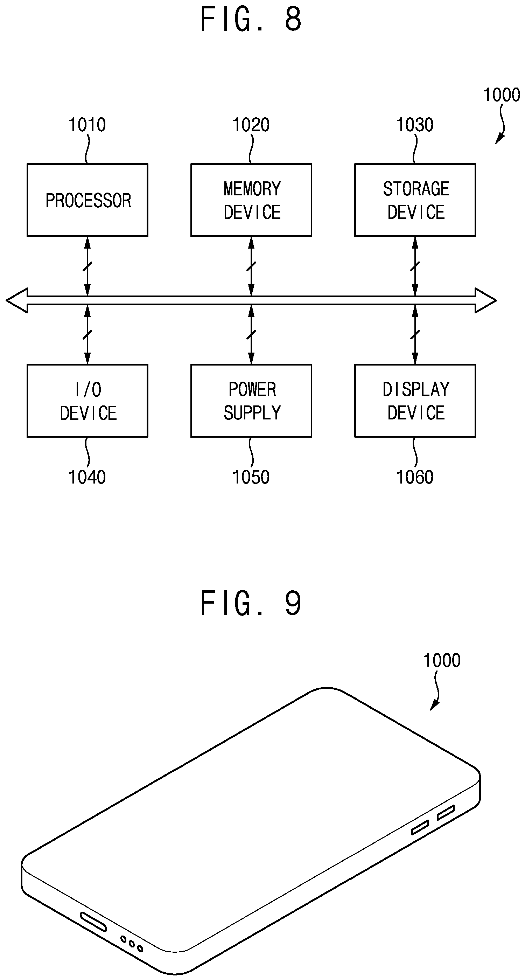

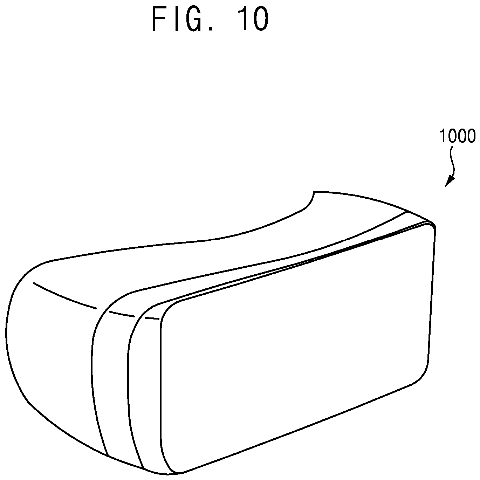

FIG. 8 is a block diagram illustrating an electronic device according to an embodiment of the present disclosure. FIG. 9 is a view illustrating an example in which the electronic device of FIG. 8 is implemented as a smart phone. FIG. 10 is a view illustrating an example in which the electronic device of FIG. 8 is implemented as a head mounted display device.

Referring to FIGS. 8, 9, and 10, an electronic device 1000 may include a processor 1010, a memory device 1020, a storage device 1030, an input/output (I/O) device 1040, a power supply 1050, and a display device 1060. The display device 1060 may be the display device DD of FIG. 1. In addition, the electronic device 1000 may further include a plurality of ports for communicating with a video card, a sound card, a memory card, a universal serial bus (USB) device, other systems, and the like.

In an embodiment, as illustrated in FIG. 9, the electronic device 1000 may be implemented as a smart phone. In another embodiment, as illustrated in FIG. 10, the electronic device 1000 may be implemented as a head mounted display device. However, the electronic device 1000 is not limited thereto. For example, the electronic device 1000 may be implemented as a smart pad, a smart watch, a tablet PC, a car navigation system, a laptop, and the like.

The processor 1010 may perform various computing functions. The processor 1010 may be a microprocessor, a central processing unit ("CPU"), an application processor ("AP"), and the like. The processor 1010 may be coupled to other components through an address bus, a control bus, a data bus, and the like. In an embodiment, the processor 1010 may be coupled to an extended bus such as a peripheral component interconnection ("PCI") bus.

The memory device 1020 may store data for operations of the electronic device 1000. For example, the memory device 1020 may include at least one non-volatile memory device such as an erasable programmable read-only memory ("EPROM") device, an electrically erasable programmable read-only memory ("EEPROM") device, a flash memory device, a phase change random access memory ("PRAM") device, a resistance random access memory ("RRAM") device, a nano floating gate memory ("NFGM") device, a polymer random access memory ("PoRAM") device, a magnetic random access memory ("MRAM") device, a ferroelectric random access memory ("FRAM") device, and the like and/or at least one volatile memory device such as a dynamic random access memory ("DRAM") device, a static random access memory ("SRAM") device, a mobile DRAM device, and the like.

The storage device 1030 may include a solid-state drive ("SSD") device, a hard disk drive ("HDD") device, a CD-ROM device, and the like. The I/O device 1040 may include an input device such as a keyboard, a keypad, a mouse device, a touch-pad, a touch-screen, and the like, and an output device such as a printer, a speaker, and the like. In some embodiments, the I/O device 1040 may include the display device 1060.

The power supply 1050 may provide power for operations of the electronic device 1000. In other words, the power supply 1050 may provide power to the display device 1060. The display device 1060 may be connected to other components through buses or other communication links.

Embodiments of the disclosure may be applied to various display devices, for example, display devices for vehicles, ships and aircraft, portable communication devices, display devices for exhibition or information transmission, medical display devices, and the like.

The invention should not be construed as being limited to the embodiments set forth herein. Rather, these embodiments are provided so that this disclosure will be thorough and complete and will fully convey the concept of the invention to those skilled in the art.

While the invention has been particularly shown and described with reference to embodiments thereof, it will be understood by those of ordinary skill in the art that various changes in form and details may be made therein without departing from the scope of the invention as defined by the following claims.

## Claims

1. A display device (DD) comprising:
a substrate (SUB) including a display area (DA), a dam area (DAMA) surrounding the display area (DA), and a pad area (PDA) spaced apart from the dam area (DAMA) in one direction;
a light emitting layer (EML) disposed in the display area (DA) on the substrate (SUB);
a dam portion (DAP) disposed in the dam area (DAMA) on the substrate;
an encapsulation layer (TFE) disposed in the display area (DA) on the light emitting layer (EML) and disposed in the dam area on the dam portion (DAP);
an organic protective layer (APL) disposed in the display area (DA) on the encapsulation layer (TFE) and including an organic material, wherein the organic protective layer (APL) directly contacts an upper surface of the encapsulation layer (TFE) in the display area, and does not overlap the dam area (DAMA) in a plan view; and
a color filter layer (CFL) disposed in the display area (DA) on the organic protective layer (APL), wherein the color filter layer (CFL) directly contacts an upper surface of the organic protective layer (APL) in the display area, and does not overlap the dam area (DAMA) in the plan view.

2. The display device (DD) of claim 1, wherein the color filter layer (CFL) is spaced apart from the encapsulation layer (TFE) with the organic protective layer (APL) interposed therebetween.

3. The display device (DD) of one of claims 1 or 2, further comprising:
a pad electrode (PDE) disposed in the pad area (PDA) on the substrate,
wherein the organic protective layer (APL) covers the pad electrode in the pad area (PDA).

4. The display device (DD) of one of the preceding claims, further comprising:
a flattening layer (OVC) disposed in the display area on the color filter layer (CFL) and disposed in the dam area (DAMA) on the encapsulation layer (TFE); and
a lens layer (LL) disposed in the display area and the dam area on the flattening layer (OVC).

5. The display device (DD) of claim **4,** wherein a level of an upper surface of the flattening layer (OVC) in the display area (DA) is different from a level of the upper surface of the flattening layer (OVC) in the dam area (DAMA).

6. The display device (DD) of one of claims 4 or 5,
wherein the lens layer (LL) includes a plurality of micro lenses (ML) overlapping the display area (DA) in the plan view, and
wherein the plurality of micro lenses (LL) are spaced apart from the dam area (DAMA) in the plan view.

7. The display device (DD) of at least one of claims 4 to 6, wherein the encapsulation layer (TFE) includes:
a first inorganic encapsulation layer (TFE1) disposed on the dam portion (DAP) and covering the dam portion (DAP);
an organic encapsulation layer (TFE2) disposed on the first inorganic encapsulation layer (TFE1), wherein the organic encapsulation layer (TFE2) does not overlap at least a portion of the dam portion (DAP) in the plan view; and
a second inorganic encapsulation layer (TFE3) disposed on the first inorganic encapsulation layer (TFE1) and covering the dam portion (DAP) and the first inorganic encapsulation layer (TFE1), and
wherein the flattening layer (OVC) directly contacts an upper surface of the second inorganic encapsulation layer (TFE3) in the dam area (DAMA).

8. The display device (DD) of claim 1, the display device (DD) further comprising:
a dummy pixel area (DPX) surrounding the display area (DA), the dam area (DAMA) surrounding the dummy pixel area (DUMA);
a dummy electrode (DME) disposed in the dummy pixel area (DUMA) on the substrate;
wherein the encapsulation layer (TFE) is disposed in the display area on the light emitting layer (EML), the encapsulation layer (TFE) is disposed in the dummy pixel area (DUMA) on the dummy electrode (DME) and the encapsulation layer (TFE) is disposed in the dam area (DAMA) on the dam portion (DAP);
wherein the organic protective layer (APL) is disposed in the display area and the dummy pixel area (DUMA) on the encapsulation layer (TFE), and including an organic material, wherein the organic protective layer (APL) directly contacts an upper surface of the encapsulation layer (TFE) in the display area (DA) and the dummy pixel area (DUMA), and does not overlap the encapsulation layer in the dam area in a plan view; and
wherein the color filter layer (CFL) is disposed in the display area (DA) and the dummy pixel area (DUMA) on the organic protective layer (APL), wherein the color filter layer (CFL) directly contacts an upper surface of the organic protective layer (APL) in the display area and the dummy pixel area (DUMA), and does not overlap the encapsulation layer in the dam area in the plan view.

9. The display device (DD) of claim 8, wherein the color filter layer (CFL) is spaced apart from the encapsulation layer (TFE) with the organic protective layer (APL) interposed therebetween.

10. The display device (DD) of one of claims 8 or 9, further comprising:
a pad electrode (PDE) disposed in the pad area (PDA) on the substrate,
wherein the organic protective layer (APL) covers the pad electrode (PDE) in the pad area.

11. The display device (DD) of at least one of claims 8 to 10, further comprising:
a flattening layer (OVC) disposed in the display area (DA) and the dummy pixel area (DUMA) on the color filter layer (CFL) and disposed in the dam area (DAMA) on the encapsulation layer (TFE); and
a lens layer (LL) disposed in the display area (DA), the dummy pixel area (DUMA), and the dam area on the flattening layer.

12. The display device (DD) of claim 11, wherein a level of an upper surface of the flattening layer (OVC) in the display area (DA) is equal to a level of the upper surface of the flattening layer (OVC) in the dummy pixel area (DUMA).

13. The display device (DD) of one of claims 11 or 12, wherein a level of an upper surface of the flattening layer (OVC) in the display area (DA) is different from a level of the upper surface of the flattening layer (OVC) in the dam area (DAMA).

14. The display device (DD) of one of claims 11 to 13, wherein the encapsulation layer (TFE) includes:
a first inorganic encapsulation layer (TFE1) disposed on the dam portion (DAP) and covering the dam portion;
an organic encapsulation layer (TFE2) disposed on the first inorganic encapsulation layer (TFE1), wherein the organic encapsulation layer (TFE2) does not overlap at least a portion of the dam portion (DAP) in the plan view; and
a second inorganic encapsulation layer (TFE3) disposed on the first inorganic encapsulation layer (TFE1) and covering the dam portion (DAP) and the first inorganic encapsulation layer (TFE1), and
wherein the flattening layer (OVC) directly contacts an upper surface of the second inorganic encapsulation layer (TFE3) in the dam area (DAMA).

15. An electronic device (1000) comprising:
the display device (DD) according to one of the preceding claims; and
a power supply (1050) configured to provide power to the display device (DD).
